# FASCICULE DE BREVET EUROPEEN

(11) **EP 3 732 723 B1**
(45) Date de publication et mention de la délivrance du brevet: **17.08.2022**
(21) Numéro de dépôt: 18816205.1
(22) Date de dépôt: 21.11.2018
(51) Int. Cl.: H01L 27/15, H01L 33/12

(54) **PSEUDO-SUBSTRAT POUR DISPOSITIF OPTOÉLECTRONIQUE ET SON PROCÉDÉ DE FABRICATION**
PSEUDOSUBSTRAT FÜR EINE OPTOELEKTRONISCHE VORRICHTUNG UND VERFAHREN ZU DESSEN HERSTELLUNG
PSEUDOSUBSTRATE FOR OPTOELECTRONIC DEVICE AND METHOD FOR MANUFACTURING SAME

(30) Priorité: 27.12.2017 FR 1763274
(43) Date de publication de la demande: 04.11.2020
(73) Titulaire: Aledia, 38130 Echirolles (FR)
(72) Inventeur: ROBIN, Ivan-Christophe, 38000 Grenoble (FR); NAPIERALA, Jérôme, 38120 Saint Egrève (FR)
(74) Mandataire: Germain Maureau
(86) Numéro de dépôt international: PCT/FR2018/052936
(87) Numéro de publication internationale: WO 2019/129945

(56) Documents cités:
- EP-A2- 2 665 100
- WO-A1-2016/116703

## Description

### DOMAINE TECHNIQUE

La présente invention concerne un pseudo-substrat pour dispositif optoélectronique, adapté à la croissance de diodes électroluminescentes sur le pseudo-substrat, le pseudo-substrat comprenant un substrat et une structure tampon formée sur une face supérieure du substrat.

L'invention concerne également un procédé de fabrication d'un tel pseudo-substrat, un dispositif optoélectronique en tant que tel et un procédé d'obtention d'un tel dispositif optoélectronique.

L'invention trouve une application notamment dans les écrans d'affichage ou les systèmes de projection d'images.

### ETAT DE LA TECHNIQUE ANTERIEURE

Par dispositif optoélectronique, on entend un dispositif adapté à effectuer la conversion d'un signal électrique en un rayonnement électromagnétique, et notamment un dispositif dédié à l'émission d'un rayonnement électromagnétique, notamment de la lumière.

A cet effet, un dispositif optoélectronique comprend classiquement des diodes électroluminescentes, également connues sous l'acronyme LED pour « light-emitting diode » selon la terminologie anglo-saxonne consacrée.

Il est connu que chaque diode électroluminescente comprenne un matériau actif exploitant des puits quantiques, une portion semiconductrice dopée selon un premier type de dopage pour jouer le rôle de jonction dopée P et une portion semiconductrice dopée selon un deuxième type de dopage pour jouer le rôle de jonction dopée N.

Chaque diode électroluminescente peut être formée sur la base d'éléments tridimensionnels semiconducteurs, eux-mêmes au moins partiellement obtenus par croissance par épitaxie. Les diodes électroluminescentes sont typiquement formées à base d'un matériau semiconducteur comprenant des éléments de la colonne III et de la colonne V du tableau périodique, tel qu'un composé III-V, notamment le nitrure de gallium (GaN), le nitrure d'indium et de gallium (InGaN) ou le nitrure d'aluminium et de gallium (AIGaN).

Il existe des dispositifs optoélectroniques comportant une matrice de diodes électroluminescentes présentant une certaine surface d'émission. De tels dispositifs optoélectroniques peuvent notamment être utilisés dans la constitution d'écrans d'affichage ou de systèmes de projection d'images, où la matrice de diodes électroluminescentes définit en fait une matrice de pixels lumineux où chaque pixel comporte une ou plusieurs diode(s) électroluminescente(s).

L'une des difficultés est de parvenir à ce que chaque pixel puisse émettre des lumières de différentes couleurs, par exemples bleues, vertes et rouges.

Une première solution connue prévoit que la matrice soit organisée de telle sorte que chaque pixel comprenne au moins une diode électroluminescente apte à émettre de la lumière bleue, au moins une diode électroluminescente apte à émettre de la lumière verte et au moins une diode électroluminescente apte à émettre de la lumière rouge. Pour y parvenir, les diodes électroluminescentes qui sont aptes à émettre une lumière dans une couleur donnée sont fabriquées sur un même substrat, cela étant répété séparément pour les trois couleurs. Puis chaque substrat est découpé afin de délimiter des dispositifs individuels. Chaque pixel est alors obtenu par reconstruction afin d'associer de tels dispositifs individuels de manière à disposer des trois couleurs.

Cette solution également connue sous le nom de « pick and place » selon la terminologie anglo-saxonne consacrée n'est pas optimale car elle engendre de nombreuses manipulations, un temps de fabrication et des coûts élevés, ainsi qu'un nombre de connexions important. Compte tenu de la miniaturisation toujours croissante, cette solution peut même parfois s'avérer malheureusement impossible à mettre en œuvre.

D'autre part, généralement la couleur rouge est obtenue à partir d'InGaAlP mais cette technique présente des désavantages tels que le fait de présenter une variation importante de la longueur d'onde en fonction de la température, le fait de varier d'efficacité en fonction de la tailles des diodes électroluminescentes (l'efficacité diminuant pour des micro diodes inférieures à 30 microns) et le fait que la croissance de ce matériau est délicate.

Une deuxième solution consiste à prévoir que les diodes électroluminescentes soient adaptées à émettre une lumière dans les couleurs bleues. Afin que le pixel lumineux puisse émettre dans les couleurs vertes et/ou dans les couleurs rouges, ce dernier peut comporter des plots photoluminescents jouant le rôle de convertisseur de couleur : chaque plot photoluminescent est conçu de sorte à absorber au moins une partie de la lumière bleue émise par les diodes électroluminescentes et à émettre en réponse une lumière verte ou rouge. Ces plots photo-luminescents sont habituellement formés d'une matrice liante adaptée.

Toutefois, cette solution ne donne pas une entière satisfaction car les plots photoluminescents induisent des pertes lumineuses élevées. Généralement, le taux de conversion des plots est en effet compris entre 50% et 80%. De plus, elle reste complexe et assez coûteuse à mettre en œuvre en raison des opérations dédiées à la fabrication des plots photoluminescents. Les documents WO 2016/116703 A1 et EP 2 665 100 A2 décrivent des dispositifs optoélectroniques comportant au moins deux diodes électroluminescentes obtenues par croissance épitaxiale émettant à deux longueurs d'onde différentes.

### EXPOSE DE L'INVENTION

La présente invention vise à résoudre tout ou partie des inconvénients présentés ci-avant.

Dans ce contexte, un objectif est donc de fournir une solution répondant à au moins l'un des objectifs suivants :
- proposer une fabrication simple et économique,
- avoir un rendement lumineux élevé
- incorporer des quantités élevées d'In, notamment dans une proportion supérieure à 20%, dans des puits quantiques d'InGaN sans dégrader l'efficacité des puits, notamment pour s'affranchir du recours à de l'InGaAlP.

Cet objectif peut être atteint grâce à la fourniture d'un pseudo-substrat pour dispositif optoélectronique, le pseudo-substrat étant adapté à la croissance de diodes électroluminescentes sur le pseudo-substrat, le pseudo-substrat comprenant un substrat et une structure tampon formée sur une face supérieure du substrat, la structure tampon comprenant :
- au moins une première partie où une couche formée en nitrure de gallium massif délimite au moins une surface libre d'un premier type tournée du côté opposé à la face supérieure du substrat, chaque surface libre du premier type étant adaptée à la croissance sur celle-ci d'au moins une diode électroluminescente majoritairement à base d'un composé III-V apte à émettre de la lumière à une première longueur d'onde,
- et au moins une deuxième partie où un empilement alternant des couches de nitrure d'indium et de gallium et des couches intermédiaires de GaN et dans lequel l'indium est présent dans une première proportion massique, délimite au moins une surface libre d'un deuxième type tournée du côté opposé à la face supérieure du substrat, chaque surface libre du deuxième type étant adaptée à la croissance sur celle-ci d'au moins une diode électroluminescente majoritairement à base d'un composé III-V apte à émettre de la lumière à une deuxième longueur d'onde différente de la première longueur d'onde,
- ladite au moins une deuxième partie de la structure tampon étant décalée par rapport à ladite au moins une première partie de la structure tampon dans un plan général orienté parallèlement au plan de la face supérieure du substrat.

Un tel pseudo-substrat permet de répondre aux problèmes présentés ci-avant car il permet la croissance, sur les surfaces libres des différentes parties de la structure tampon, de diodes électroluminescentes aptes à émettre de la lumière à différentes longueurs d'ondes : typiquement du bleu et du rouge, du bleu et du vert, voire les trois. Autrement dit, un seul et même pseudo-substrat permet de parvenir à la fourniture, après obtention du dispositif optoélectronique, de pixels lumineux polychromes par simple croissance de diodes électroluminescentes sur les surfaces libres des différentes parties de la structure tampon. Cette technique permet de s'affranchir de la nécessité de recourir à la première solution décrite en lien avec l'état de la technique ou de la nécessité de devoir recourir à des convertisseurs de couleurs.

En outre, l'ensemble des diodes électroluminescentes qui sont aptes à émettre des lumières de couleurs différentes sont pourtant très avantageusement obtenues par processus de croissance identique quelle que soit la surface libre considérée de la structure tampon ; la nature du matériau de la structure tampon au niveau de chacune des surfaces libres de premier type et de deuxième type assure une adaptation de la couleur de la lumière qui est émise par les diodes électroluminescentes formées sur ces surfaces libres entre une couleur bleue, une couleur verte et/ou une couleur rouge.

Par ailleurs, la fourniture d'un tel pseudo-substrat permet très avantageusement d'incorporer des quantités élevées d'Indium, notamment dans une proportion supérieure à 20%, dans des puits quantiques d'InGaN sans dégrader l'efficacité des puits.

Le pseudo-substrat peut également répondre aux caractéristiques techniques présentées ci-après, prises isolément ou en combinaison.

Au niveau de ladite au moins une deuxième partie de la structure tampon, l'empilement alternant des couches de InGaN et des couches intermédiaires de GaN est au moins partiellement formé sur la face supérieure du substrat, et le pseudo-substrat comprenant une couche de nucléation formée sur la face supérieure du substrat, au niveau de ladite au moins une deuxième partie de la structure tampon l'empilement alternant des couches de InGaN et des couches intermédiaires de GaN est au moins partiellement formé sur la couche de nucléation.

L'empilement alternant des couches de InGaN et des couches intermédiaires de GaN de ladite au moins une deuxième partie se présente sous la forme d'au moins un nano-élément en forme de fil ou en forme de pyramide.

La structure tampon comprend au moins une troisième partie où un empilement alternant des couches de InGaN et des couches intermédiaires de GaN et dans lequel l'indium est présent dans une deuxième proportion massique strictement différente de la première proportion massique, délimite au moins une surface libre d'un troisième type tournée du côté opposé à la face supérieure du substrat, chaque surface libre du troisième type étant adaptée à la croissance sur celle-ci d'au moins une diode électroluminescente majoritairement à base d'un composé III-V apte à émettre de la lumière à une troisième longueur d'onde différente de la première longueur d'onde et de la deuxième longueur d'onde, et ladite au moins une troisième partie de la structure tampon est décalée par rapport à ladite au moins une première partie de la structure tampon et par rapport à ladite au moins une deuxième partie de la structure tampon dans le plan général orienté parallèlement au plan de la face supérieure du substrat.

Au niveau de ladite au moins une troisième partie de la structure tampon, l'empilement alternant des couches de InGaN et des couches intermédiaires de GaN est au moins partiellement formé sur la face supérieure du substrat, et le pseudo-substrat comprenant une couche de nucléation formée sur la face supérieure du substrat, au niveau de ladite au moins une troisième partie de la structure tampon l'empilement alternant des couches de InGaN et des couches intermédiaires de GaN est au moins partiellement formé sur la couche de nucléation.

L'empilement alternant des couches de InGaN et des couches intermédiaires de GaN de ladite au moins une troisième partie se présente sous la forme d'au moins un nano-élément en forme de fil ou en forme de pyramide.

La première proportion massique de l'indium au niveau de ladite au moins une deuxième partie (22) est incluse dans une plage entre 5 et 25%, préférentiellement entre 10 et 20%.

La deuxième proportion massique de l'indium au niveau de ladite au moins une troisième partie (23) est incluse dans une plage entre 5 et 25%, préférentiellement entre 10 et 20%.

L'invention concerne aussi un dispositif optoélectronique comprenant un tel pseudo-substrat et :
- au moins une diode électroluminescente majoritairement à base d'un composé III-V formée par croissance sur la surface libre du premier type de ladite au moins une première partie de la structure tampon du pseudo-substrat et apte à émettre de la lumière à la première longueur d'onde,
- au moins une diode électroluminescente majoritairement à base d'un composé III-V formée par croissance sur la surface libre du deuxième type de ladite au moins une deuxième partie de la structure tampon du pseudo-substrat et apte à émettre de la lumière à la deuxième longueur d'onde différente de la première longueur d'onde.

Le dispositif optoélectronique comprend au moins une diode électroluminescente majoritairement à base d'un composé III-V formée par croissance sur la surface libre du troisième type de ladite au moins une troisième partie de la structure tampon du pseudo-substrat et apte à émettre de la lumière à la troisième longueur d'onde différente de la première longueur d'onde et de la deuxième longueur d'onde.

L'invention concerne aussi un procédé de fabrication d'un tel pseudo-substrat qui comprend une première étape de fourniture du substrat, une deuxième étape de formation de la couche formée en GaN massif sur la face supérieure du substrat, une troisième étape de formation de l'empilement alternant des couches de InGaN et des couches intermédiaires de GaN et dans lequel l'indium est présent dans la première proportion massique, sur la couche résultant de la deuxième étape et/ou sur la face supérieure du substrat.

La troisième étape peut comprendre des étapes successives de dépôt de couches d'InGaN et de couches intermédiaires de GaN dans des ouvertures délimitées par un premier masque recouvrant la couche de GaN massif résultant de la deuxième étape.

Alternativement, la troisième étape peut comprendre un premier ensemble d'étapes successives de dépôt de couches d'InGaN et de couches intermédiaires de GaN sur toute la surface de la couche résultant de la deuxième étape, puis une première étape de gravure à travers un empilement qui résulte dudit premier ensemble d'étapes successives de dépôt, ladite première étape de gravure étant réalisée de sorte à rendre libres des surfaces déterminées de la couche qui résulte de la deuxième étape, lesdites surfaces rendues libres correspondant aux surfaces libres de premier type de ladite au moins une première partie de la structure tampon.

Le procédé peut comprendre une quatrième étape de formation de l'empilement alternant des couches de InGaN et des couches intermédiaires de GaN et dans lequel l'indium est présent dans la deuxième proportion massique, sur la couche résultant de la deuxième étape et/ou sur l'empilement résultant de la troisième étape.

Selon un mode de réalisation particulier, la quatrième étape comprend des étapes successives de dépôt de couches d'InGaN et de couches intermédiaires de GaN dans tout ou partie de la surface d'ouvertures d'un deuxième masque recouvrant au moins la couche de GaN massif qui résulte de la deuxième étape.

La quatrième étape peut comprendre un deuxième ensemble d'étapes successives de dépôt de couches d'InGaN et de couches intermédiaires de GaN sur toute la surface de l'empilement résultant du premier ensemble d'étapes successives de dépôt, puis une deuxième étape de gravure à travers un empilement qui résulte dudit deuxième ensemble d'étapes successives de dépôt, ladite deuxième étape de gravure étant réalisée de sorte à rendre libres des surfaces déterminées de l'empilement qui résulte du premier ensemble d'étapes successives de dépôt, lesdites surfaces rendues libres correspondant aux surfaces libres de deuxième type de ladite au moins une deuxième partie de la structure tampon.

### BREVE DESCRIPTION DES DESSINS

L'invention sera encore mieux comprise à l'aide de la description qui suit de modes particuliers de réalisation de l'invention donnés à titre d'exemples non limitatifs et représentés sur les dessins annexés, dans lesquels :
La figure 1 est une vue schématique d'un premier mode de réalisation d'un pseudo-substrat selon un aspect de l'invention.
La figure 2 est une vue schématique d'un premier mode de réalisation d'un dispositif optoélectronique selon un autre aspect de l'invention.
Les figures 3 à 7 représentent différentes étapes successives d'un premier mode d'exécution d'un procédé de fabrication du pseudo-substrat.
Les figures 8 et 9 représentent différentes étapes successives d'un deuxième mode d'exécution d'un procédé de fabrication du pseudo-substrat.
La figure 10 illustre schématiquement un deuxième mode de réalisation d'un dispositif optoélectronique selon l'invention.
La figure 11 est une vue schématique d'un deuxième mode de réalisation d'un pseudo-substrat selon l'invention.
La figure 12 est une vue schématique d'un troisième mode de réalisation d'un pseudo-substrat selon l'invention.
La figure 13 est une vue schématique d'un quatrième mode de réalisation d'un pseudo-substrat selon l'invention.

### EXPOSE DETAILLE DE MODES DE REALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures.

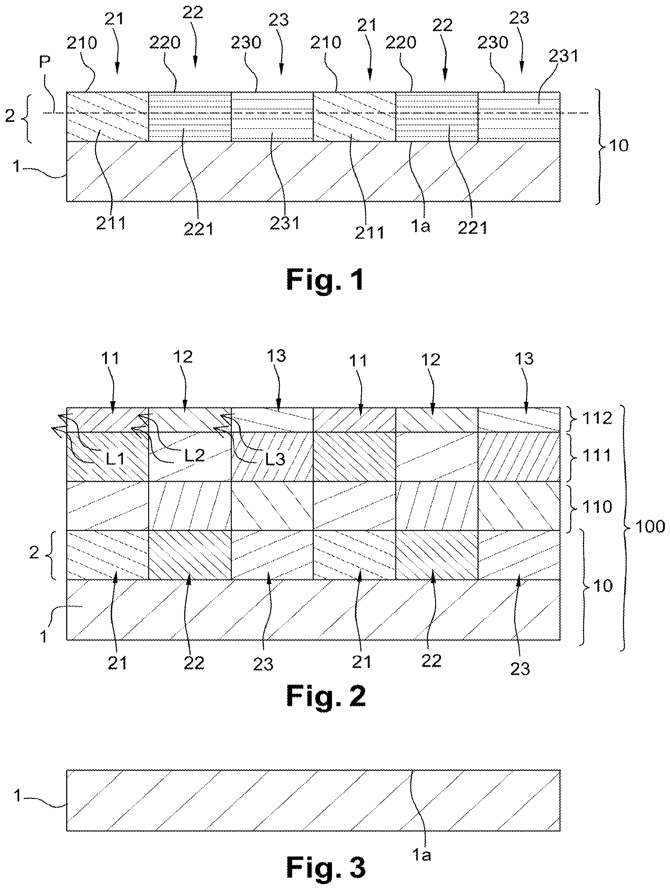

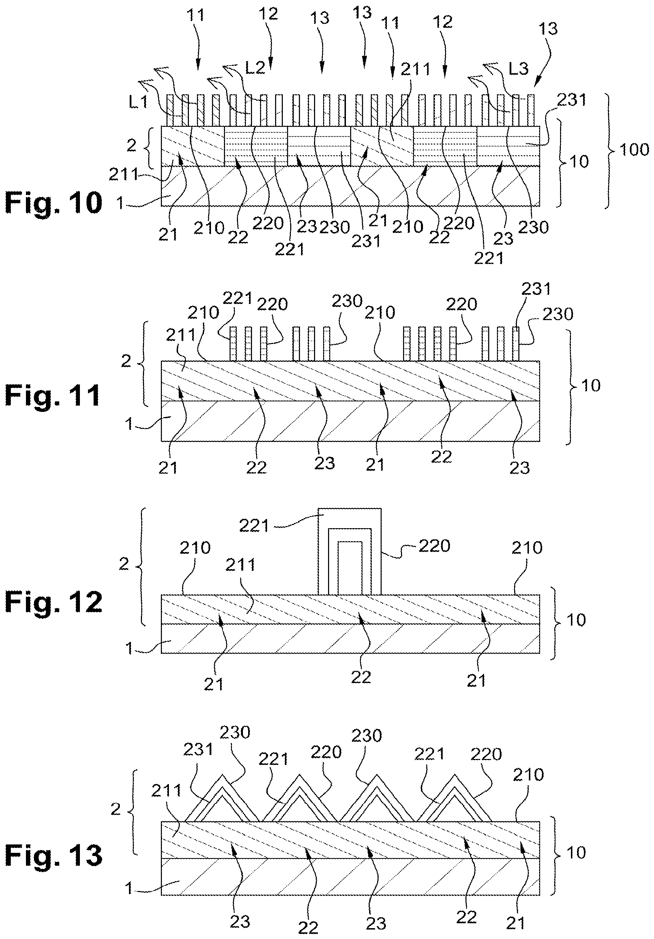

Les figures 1 et 11 représentent, de manière schématique, respectivement des premier et deuxième modes de réalisation d'un pseudo-substrat 10 selon un aspect de l'invention, ces deux modes de réalisation étant toutefois non limitatifs et illustrés uniquement à titre d'exemple pour faciliter la compréhension de l'invention. Chacun de ces deux pseudo-substrats 10 est configuré de sorte à pouvoir servir à la fabrication ultérieure d'un dispositif optoélectronique 100. L'invention trouvera une application notamment dans la fabrication d'écrans d'affichage ou de systèmes de projection d'images sur la base d'un tel dispositif optoélectronique 100.

Le pseudo-substrat 10 est notamment adapté à la croissance de diodes électroluminescentes sur des surfaces libres délimitées par une structure tampon 2 du pseudo-substrat 10 formée sur une face supérieure la d'un substrat 1. Plus précisément, les diodes électroluminescentes sont destinées à être formées sur la structure tampon 2 d'un côté opposé au substrat 1 vu dans une direction perpendiculaire au plan du substrat 1.

Selon un mode de réalisation, le substrat 1 est constitué en silicium, en semiconducteur III-V (par exemple en GaN) massif, en saphir ou en spinelle. Il peut alternativement s'agir d'un substrat de type silicium sur isolant ou « SOI » pour « Silicon On Insulator » selon la terminologie anglo-saxonne consacrée.

La structure tampon 2 peut être formée directement sur la face supérieure la du substrat 1, moyennant un contact direct entre le substrat 1 et les couches de la structure tampon 2. Alternativement, la structure tampon 2 peut être formée indirectement sur le substrat 1 dans l'hypothèse où une couche intermédiaire serait présente entre le substrat 1 et la structure tampon 2, comme par exemple une couche de nucléation non représentée.

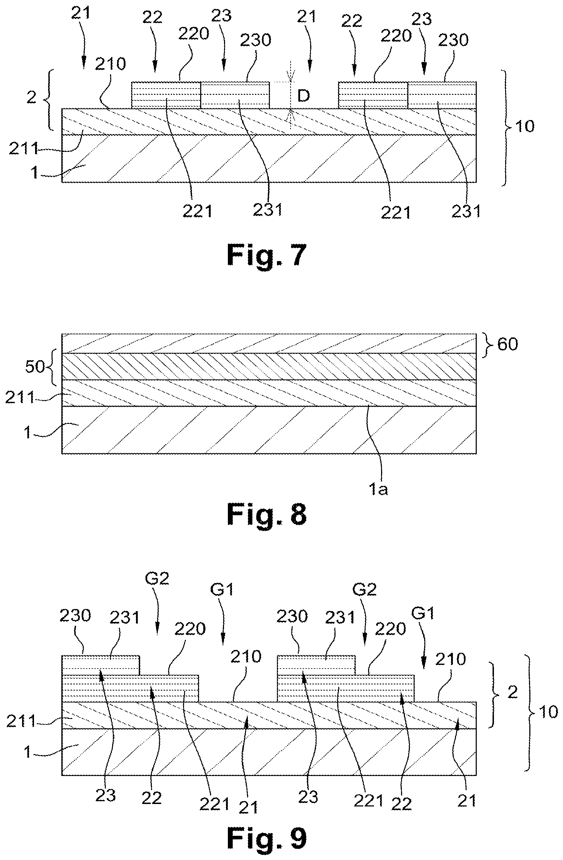

Essentiellement, les deux modes de réalisation des figures 1 et 11 diffèrent l'un de l'autre quant à la manière de former la structure tampon 2, même si les principes généraux présentés plus loin sont appliqués dans chacun des deux modes de réalisation. Les figures 7 et 9 montrent encore deux autres modes de réalisation supplémentaires d'un pseudo-substrat 10 selon l'invention.

La nature et l'organisation de la structure tampon 2 qui est formée sur le substrat 1 représentent une véritable avancée par rapport à l'état de la technique présenté dans ce document, dans le but de présenter une fabrication simple et économique tout en limitant les connexions et les manipulations des diodes électroluminescentes et/ou d'obtenir un rendement lumineux élevé pour le dispositif optoélectronique 100.

A cet effet, la structure tampon 2 comprend au moins une première partie 21 où une couche 211 formée en nitrure de gallium (GaN) massif délimite au moins une surface libre d'un premier type 210 tournée du côté opposé à la face supérieure la du substrat 1. Chaque surface libre du premier type 210 est adaptée à la croissance sur celle-ci d'au moins une diode électroluminescente 11 majoritairement à base d'un composé III-V apte à émettre de la lumière L1 (schématisée aux figures 2 et 10) à une première longueur d'onde. La première longueur d'onde dépend directement de la composition du matériau délimitant la surface libre du premier type 210.

En complément, la structure tampon 2 comprend au moins une deuxième partie 22 où un empilement 221 alternant des couches de nitrure d'indium et de gallium (InGaN) et des couches intermédiaires de GaN et dans lequel l'indium est présent dans une première proportion massique donnée, délimite au moins une surface libre d'un deuxième type 220 tournée du côté opposé à la face supérieure la du substrat 1. Chaque surface libre du deuxième type 220 est adaptée à la croissance sur celle-ci d'au moins une diode électroluminescente 12 majoritairement à base d'un composé III-V apte à émettre de la lumière L2 (schématisée aux figures 2 et 10) à une deuxième longueur d'onde différente de la première longueur d'onde mentionnée dans le paragraphe précédent. La deuxième longueur d'onde dépend directement de la composition du matériau délimitant la surface libre du deuxième type 220.

A titre d'exemple, chaque couche d'InGaN présente une épaisseur inférieure à 9 nm et chaque couche intermédiaire de GaN présente une épaisseur supérieure à 9 nm.

Ainsi, un pixel lumineux apte à émettre deux lumières L1 et L2 à deux longueurs d'ondes distinctes peut être formé lors du même procédé de fabrication et cela permet de diminuer considérablement le nombre de manipulation, le temps de fabrication, le nombre de connexions et/ou le nombre de tests. Cela permet également de s'affranchir de la nécessité de recourir à des convertisseurs de couleurs, facilitant encore la fabrication et permettant d'atteindre de très bons rendements lumineux.

Sur la figure 1, le pseudo-substrat 10 comporte deux premières parties 21 et deux deuxièmes parties 22, délimitant uniquement à titre d'exemple et d'illustration, deux surfaces libres du premier type 210 distinctes et deux surfaces libres du deuxième type 220 distinctes. Il va de soi que le nombre de surfaces libres de premier type 210 et leur répartition peuvent être quelconques. Il en est de même pour les surfaces libres de deuxième type 220.

Comme cela est visible sur les figures 1, 7, 9 ou 11, ladite au moins une deuxième partie 22 de la structure tampon 2 est décalée par rapport à ladite au moins une première partie 21 de la structure tampon 2 dans un plan général P (visible sur la figure 1) orienté parallèlement au plan de la face supérieure la du substrat 1. De tels décalages dans le plan général P entre les différentes surface libres de premier type et de deuxième type 210, 220 permet, une fois que les diodes électroluminescentes 11, 12 sont formées sur celles-ci, d'assurer une répartition des diodes électroluminescente 11, 12 dans le plan parallèle au plan du substrat 1. Cette disposition est avantageuse pour la fabrication d'écrans d'affichage ou de systèmes de projection d'images nécessitant une surface d'émission où les pixels lumineux sont répartis.

Il est insisté sur le fait que la figure 1 n'apporte pas vraiment de limitation dimensionnelle ou organisationnelle de la structure tampon 2. Ainsi, chaque surface libre du premier type 210 peut être plane, ou non. Les surfaces libres de premier type 210 peuvent être situées dans le même plan que les surfaces libres de deuxième type 220, ou non (en ce sens qu'il peut y avoir un décalage vertical de l'une à l'autre suivant la direction perpendiculaire au plan général P, c'est-à-dire perpendiculairement au plan du substrat 1). De même, chaque surface libre du deuxième type 220 peut être plane, ou non. En ce sens, la figure 11 illustre un cas particulier dans lequel l'empilement 221 qui alterne des couches de InGaN et des couches intermédiaires de GaN de ladite au moins une deuxième partie 22 se présente sous la forme d'au moins un nanofil formé sur la couche 211 formée en GaN massif. De tels empilements 221 sous la forme de nanofils peuvent être obtenus par toute technique connue, par exemple par gravure à travers un empilement GaN/InGaN plus étendu dans le plan P, ou encore par exemple par croissances successives à travers des masques correspondants. Une telle organisation peut en particulier faciliter la formation des diodes électroluminescentes en forme de nanofils sur de telles surfaces libres du deuxième type 220 elles-mêmes en forme de nanofils, qu'il s'agisse de diodes électroluminescentes ayant une structure cœur-coquille ou une structure axiale.

Si la figure 11 illustre le cas particulier où les couches d'InGaN et les couches intermédiaires sont empilées axialement le long de la hauteur du nanofil qu'elles constituent, la figure 12 illustre un mode de réalisation alternatif où, pour constituer l'empilement 221, ces couches seraient empilées de manière concentrique selon une structure cœur-coquille avec un cœur d'InGaN puis une couche de GaN intermédiaire recouvrant les bordures latérales et supérieure de ce cœur, puis une couche d'InGaN recouvrant les bordures latérales et supérieure de la couche intermédiaire de GaN, puis une nouvelle couche intermédiaire de GaN, etc.

La figure 13 illustre un autre mode de réalisation dans lequel l'empilement 221 qui alterne des couches de InGaN et des couches intermédiaires de GaN de ladite au moins une deuxième partie 22 se présente sous la forme d'au moins une pyramide formée sur la couche 211 formée en GaN massif. De tels empilements 221 sous la forme de pyramides peuvent être obtenus par toute technique connue. Une telle organisation peut en particulier faciliter la formation des diodes électroluminescentes en forme de pyramides sur de telles surfaces libres du deuxième type 220 elles-mêmes en forme de pyramides, notamment des diodes électroluminescentes ayant une structure cœur-coquille.

En fonction des besoins quant à l'organisation de la structure tampon 2 suivant les applications et/ou en fonction du procédé de fabrication retenu pour la fabrication du pseudo-substrat 10, il est possible de prévoir qu'au niveau de ladite au moins une deuxième partie 22 de la structure tampon 2, l'empilement 221 qui alterne des couches de InGaN et des couches intermédiaires de GaN soit au moins partiellement formé sur la face supérieure la du substrat 1. C'est par exemple le cas dans le mode de réalisation de la figure 1, mais ce n'est pas le cas dans les modes de réalisation des figures 11, 12 et 13. Par « formé sur », on entend que l'empilement 221 peut être formé directement sur la face supérieure la du substrat 1 ou peut être formé indirectement sur celle-ci avec interposition d'une couche de nucléation formée sur la face supérieure la et sur laquelle l'empilement 221 serait formé. Ce dernier cas est avantageusement prévu lorsque le substrat 1 est en saphir ou en silicium.

Pour les mêmes raisons, il peut être prévu qu'au niveau de ladite au moins une deuxième partie 22 de la structure tampon 2, l'empilement 221 qui alterne des couches de InGaN et des couches intermédiaires de GaN soit au moins partiellement formé sur la couche 211 de GaN massif. C'est par exemple le cas dans les modes de réalisation des figures 11, 12 et 13, mais ce n'est pas le cas dans le mode de réalisation de la figure 1.

Ces différentes possibilités découleront également du fait que le procédé de fabrication selon les figures 3 à 7 soit implémenté ou non, ou bien que le procédé de fabrication associé aux figures 8 et 9 soit exécuté ou non.

En complément des différentes premières parties 21 et des différentes deuxièmes parties 22, la structure tampon 2 peut facultativement mais avantageusement comprendre au moins une troisième partie 23 où un empilement 231 alternant des couches de InGaN et des couches intermédiaires de GaN et dans lequel l'indium est présent dans une deuxième proportion massique différente de la première proportion massique précédemment évoquée, délimite au moins une surface libre d'un troisième type 230 tournée du côté opposé à la face supérieure la du substrat 1. Chaque surface libre du troisième type 230 est adaptée à la croissance sur celle-ci d'au moins une diode électroluminescente 13 majoritairement à base d'un composé III-V apte à émettre de la lumière L3 (schématisée sur les figures 2 et 10) à une troisième longueur d'onde différente de la première longueur d'onde et de la deuxième longueur d'onde. La troisième longueur d'onde dépend directement de la composition du matériau délimitant la surface libre du troisième type 230.

Comme cela est visible sur les figures 1, 7, 9, 11 ou 13, ladite au moins une troisième partie 23 de la structure tampon 2 est décalée par rapport à ladite au moins une première partie 21 de la structure tampon 2 et par rapport à ladite au moins une deuxième partie 22 de la structure tampon 2 (ainsi que par rapport à toutes les autres troisièmes parties 23 éventuelles) dans le plan général P. Là encore, une telle répartition des surfaces libres du troisième type 230 par rapport aux autres surfaces libres 210, 220, 230 favorise la fabrication d'écrans d'affichage ou de systèmes de projection d'images nécessitant une surface d'émission où les pixels lumineux sont répartis.

Sur la figure 1, le pseudo-substrat 10 comporte deux troisièmes parties 23 délimitant, uniquement à titre d'exemple et d'illustration, deux surfaces libres du troisième type 230 distinctes. Il va de soi que le nombre de surfaces libres de premier type 230 et leur répartition peuvent être quelconques.

Par la présence combinée de surfaces libres du premier type 210, de surfaces libres du deuxième type 220 et de surfaces libres du troisième type 230, il est possible de constituer des pixels lumineux aptes à émettre trois sortes de lumières L1, L2 et L3 à trois longueurs d'ondes différentes, sans nécessiter de convertisseurs de lumière. Ainsi, le rendement lumineux reste élevé tandis que la solution décrite ici supprime les obligations de découpe des substrats puis de reconstruction des pixels lumineux.

Une fois encore, en fonction des besoins quant à l'organisation de la structure tampon 2 suivant les applications et/ou en fonction du procédé de fabrication retenu pour la fabrication du pseudo-substrat 10, il est possible de prévoir qu'au niveau de ladite au moins une troisième partie 23 de la structure tampon 2, l'empilement 231 qui alterne des couches de InGaN et des couches intermédiaires de GaN soit au moins partiellement formé sur la face supérieure la du substrat 1. C'est par exemple le cas dans le mode de réalisation de la figure 1, mais ce n'est pas le cas dans les modes de réalisation des figures 11 et 13. Par « formé sur », on entend que l'empilement 231 peut être formé directement sur la face supérieure la du substrat 1 ou peut être formé indirectement sur celle-ci avec interposition de la couche de nucléation formée sur la face supérieure la et sur laquelle l'empilement 231 serait formé. Pour les mêmes raisons, il peut être prévu qu'au niveau de ladite au moins une troisième partie 23 de la structure tampon 2, l'empilement 231 qui alterne des couches de InGaN et des couches intermédiaires de GaN soit au moins partiellement formé sur la couche 211 de GaN massif et/ou sur l'empilement 221 de ladite au moins une deuxième partie 22. C'est par exemple le cas dans les modes de réalisation des figures 11 et 13, mais ce n'est pas le cas dans le mode de réalisation de la figure 1.

Les surfaces libres de troisième type 230 peuvent être situées dans le même plan que les surfaces libres 210, 220, ou non (en ce sens qu'il peut y avoir un décalage vertical de l'une à l'autre suivant la direction perpendiculaire au plan général P, c'est-à-dire perpendiculairement au plan du substrat 1). Chaque surface libre du troisième type 230 peut être plane (comme c'est le cas sur la figure 1 à titre d'illustration), ou non. En ce sens, la figure 11 illustre un cas particulier dans lequel l'empilement 231 qui alterne des couches de InGaN et des couches intermédiaires de GaN de ladite au moins une troisième partie 23 se présente sous la forme d'au moins un nanofil formé sur la couche 211 de GaN massif. De tels empilements 231 sous la forme de nanofils peuvent être obtenus par toute technique connue, par exemple par gravure à travers un empilement GaN/InGaN plus étendu dans le plan P, ou encore par exemple par croissances successives à travers des masques correspondants. Une telle organisation peut en particulier faciliter la formation des diodes électroluminescentes 13 en forme de nanofils sur de telles surfaces libres du troisième type 230 elles-mêmes en forme de nanofils, qu'il s'agisse de diodes électroluminescentes ayant une structure cœur-coquille ou une structure axiale.

La figure 13 illustre de manière alternative le fait que, pour constituer l'empilement 231 qui alterne des couches de InGaN et des couches intermédiaires de GaN de ladite au moins une troisième partie 23 se présente sous la forme d'au moins pyramide formée sur la couche 211 formée en GaN massif. De tels empilements 231 sous la forme de pyramides peuvent être obtenus par toute technique connue. Une telle organisation peut en particulier faciliter la formation des diodes électroluminescentes en forme de pyramides sur de telles surfaces libres du troisième type 230 elles-mêmes en forme de pyramides, notamment des diodes électroluminescentes ayant une structure cœur-coquille

Par « surface libre », on entend une surface qui n'est pas recouverte, en ce sens qu'au moment de la formation ultérieure des diodes électroluminescentes, elle permet de former au moins une telle diode électroluminescente depuis celle-ci, afin de constituer un dispositif optoélectronique 100 apte à émettre deux ou trois lumières L1, L2 et éventuellement L3 à des longueurs d'onde différentes sans pour autant être équipé de convertisseurs de couleurs comme c'était le cas avant si on souhaitait s'affranchir de la solution connue « pick and place ».

Une idée importante repose donc sur le fait, pour la Demanderesse, d'avoir identifié que la présence combinée d'au moins une surface libre de premier type 210 délimitée par une couche 211 de GaN massif et d'au moins une surface libre de deuxième type 220 délimitée par un empilement 221 alternant des couches de GaN et des couches InGaN en impliquant une présence d'indium selon la première proportion massique, permettait d'obtenir, après la formation de diodes électroluminescentes de manière identique d'une surface libre 210, 220 à l'autre, un dispositif optoélectronique 100 apte à émettre naturellement deux lumières L1 et L2 différentes, typiquement dans les couleurs bleues et rouges, ou dans les couleurs bleues et vertes.

En effet, chaque surface libre de premier type 210 est adaptée à permettre la croissance d'au moins une diode électroluminescente apte à émettre une lumière L1 de couleurs bleues. Par ajustement de la première proportion massique de l'indium dans l'empilement 221, il est possible d'ajuster finalement la deuxième longueur d'onde de la lumière L2 émise par une diode électroluminescente 12 formée sur la surface libre de deuxième type 220 délimitée par cet empilement 221.

D'autre part, il a été identifié par la Demanderesse que la présence supplémentaire d'au moins une surface libre de troisième type 230 délimitée par un empilement 231 alternant des couches de GaN et des couches InGaN en impliquant une présence d'indium selon la deuxième proportion massique, permet d'obtenir, après la formation de diodes électroluminescentes 11, 12, 13 de manière identique d'une surface libre 210, 220, 230 à l'autre, un dispositif optoélectronique 100 apte à émettre naturellement une troisième lumière L3 différente des lumières L1, L2, typiquement dans les couleurs vertes si la lumière L2 est dans les couleurs rouges, ou dans les couleurs rouges si la lumière L2 est dans les couleurs vertes.

Pour être plus précis, selon un mode de réalisation, la première proportion massique de l'indium dans l'empilement 221 au niveau de chaque deuxième partie 22 de la structure tampon 2 est incluse dans une plage entre 5% et 25%. Préférentiellement, la première proportion massique de l'indium dans l'empilement 221 au niveau de chaque deuxième partie 22 de la structure tampon 2 est incluse dans une plage entre 10% et 20%. Il a été constaté par la Demanderesse qu'une telle caractéristique permet que la lumière L2 soit dans les couleurs vertes. Typiquement, la deuxième longueur d'onde est située dans une plage allant de 500 à 560 nm.

Dans ce mode de réalisation, le dispositif optoélectronique 100 est alors apte à émettre au moins une lumière L1 dans les couleurs bleues et une lumière L2 dans les couleurs vertes.

Toujours dans ce mode de réalisation, dans l'hypothèse de l'aménagement d'au moins une troisième partie 23 dans la structure tampon 2, il sera très avantageux que la deuxième proportion massique de l'indium dans l'empilement 231 au niveau de chaque troisième partie 23 soit incluse dans une plage entre 15% et 50%. Préférentiellement, la deuxième proportion massique de l'indium dans l'empilement 231 au niveau de chaque troisième partie 23 de la structure tampon 2 est incluse dans une plage entre 20% et 35%. Il a été constaté par la Demanderesse qu'une telle caractéristique permet que la lumière L3 soit dans les couleurs rouges. Typiquement, la troisième longueur d'onde est située dans une plage allant de 600 à 700 nm.

Selon un autre mode de réalisation, la première proportion massique de l'indium dans l'empilement 221 au niveau de chaque deuxième partie 22 de la structure tampon 2 est incluse dans une plage entre 15% et 50%. Préférentiellement, la première proportion massique de l'indium dans l'empilement 221 au niveau de chaque deuxième partie 22 de la structure tampon 2 est incluse dans une plage entre 20% et 35%. Il a été constaté par la Demanderesse qu'une telle caractéristique permet que la lumière L2 soit dans les couleurs rouges. Typiquement, la deuxième longueur d'onde est située dans une plage allant de 580 à 680 nm.

Dans ce mode de réalisation, le dispositif optoélectronique 100 est alors apte à émettre au moins une lumière L1 dans les couleurs bleues et une lumière L2 dans les couleurs rouges.

Toujours dans ce mode de réalisation, dans l'hypothèse de l'aménagement d'au moins une troisième partie 23 dans la structure tampon 2, il sera très avantageux que la deuxième proportion massique de l'indium dans l'empilement 231 au niveau de chaque troisième partie 23 soit incluse dans une plage entre 5% et 25%. Préférentiellement, la deuxième proportion massique de l'indium dans l'empilement 231 au niveau de chaque troisième partie 23 de la structure tampon 2 est incluse dans une plage entre 10% et 20%. Il a été constaté par La Demanderesse qu'une telle caractéristique permettait que la lumière L3 soit dans les couleurs vertes. Typiquement, la troisième longueur d'onde est située dans une plage allant de 500 à 560 nm.

La première proportion massique d'indium dans l'empilement 221 de ladite au moins une deuxième partie 22 peut être ajustée notamment par l'intermédiaire différents paramètres, à savoir le flux d'indium durant la croissance des couches de InGaN, la température durant cette croissance, les conditions de recuit, des conditions d'implantation. Il en est de même pour l'ajustement de la deuxième proportion massique d'indium dans l'empilement 231 de ladite au moins une troisième partie 23.

Le pseudo-substrat 10 qui a été décrit précédemment est adapté à l'obtention d'un dispositif optoélectronique 100 tel que défini au début de ce document. Pour cela, des diodes électroluminescentes 11, 12 sont formées sur les différentes surfaces libres de premier type 210 et de deuxième type 220 respectivement des différentes parties 21, 22 de la structure tampon 2. Dans le cas où la structure tampon 2 comporte également ladite au moins une troisième partie 23, au moins une diode électroluminescente 13 est également formée sur les différentes surfaces libres de troisième type 230. Avantageusement, la manière de former les diodes électroluminescentes 11, 12, 13 est identique au niveau de toutes les premières et deuxièmes parties 21, 22, voire aussi au niveau de toutes les troisièmes parties 23, de la structure tampon 2. Cela rend le procédé d'obtention du dispositif optoélectronique 100 particulièrement simple, malgré tous ses avantages déjà présentés.

La fourniture d'un tel pseudo-substrat permet très avantageusement d'incorporer des quantités élevées d'Indium, notamment dans une proportion supérieure à 20%, dans des puits quantiques d'InGaN sans dégrader l'efficacité des puits.

Les figures 2 et 10 montrent deux modes de réalisation différents du dispositif optoélectronique 100. Essentiellement, les deux modes de réalisation des figures 2 et 10 diffèrent l'un de l'autre quant à la manière de former les diodes électroluminescentes 11, 12, 13 sur la structure tampon 2 du pseudo-substrat 10, même si les principes généraux présentés ci-après sont appliqués par ces deux modes de réalisation.

En référence aux figures 2 et 10, le dispositif optoélectronique 100 comprend le pseudo-substrat 10 décrit précédemment et au moins une diode électroluminescente 11 majoritairement à base d'un composé III-V formée par croissance sur la surface libre du premier type 210 de ladite au moins une première partie 21 de la structure tampon 2 du pseudo-substrat 10, cette diode électroluminescente 11 étant apte à émettre la lumière L1 à la première longueur d'onde.

Le dispositif optoélectronique 100, qu'il soit de la figure 2 ou selon la figure 10, comprend également au moins une diode électroluminescente 12 majoritairement à base d'un composé III-V formée par croissance sur la surface libre du deuxième type 220 de ladite au moins une deuxième partie 22 de la structure tampon 2 du pseudo-substrat 10, cette diode électroluminescente 12 étant apte à émettre la lumière L2 à la deuxième longueur d'onde.

Le dispositif optoélectronique 100 peut optionnellement comprendre au moins une diode électroluminescente 13 majoritairement à base d'un composé III-V formée par croissance sur la surface libre du troisième type 230 de ladite au moins une troisième partie 23 de la structure tampon 2 du pseudo-substrat 10, cette diode électroluminescente 13 étant apte à émettre de la lumière L3 à la troisième longueur d'onde.

Chaque diode électroluminescente 11, 12, 13 peut être formée sur la base d'éléments tridimensionnels semiconducteurs, eux-mêmes au moins partiellement obtenus par croissance par épitaxie à partir des surfaces libres 210, 220 voire 230. Les diodes électroluminescentes 11, 12, 13 sont donc formées à base d'un matériau semiconducteur de type composé III-V, notamment le nitrure de gallium (GaN), le nitrure d'indium et de gallium (InGaN) ou le nitrure d'aluminium et de gallium (AIGaN).

En référence au mode de réalisation de la figure 10, chaque diode électroluminescente 11, 12, 13 peut comprendre des nano-éléments semiconducteurs tridimensionnels, préférentiellement en InGaN ou en GaN dopé, de forme filaire, conique (ou pyramidale) ou tronconique. Des diodes électroluminescentes tridimensionnelles permettent de réduire les recombinaisons de surface des porteurs et sont donc potentiellement plus efficaces que des structures bidimensionnelles. Cela permet également d'améliorer la qualité du matériau des puits quantiques, d'avoir une surface développée plus grande et de disposer de diodes électroluminescentes colorées plus lumineuses.

Par contre, dans le mode de réalisation de la figure 2, les diodes électroluminescentes 11, 12, 13 sont au contraire obtenues sous la forme d'une structure monolithique formée sur la structure tampon 2 du côté opposé au substrat 1, cette structure monolithique étant apte à émettre de la lumière polychrome à partir des diodes électroluminescentes 11, 12, 13 qu'elle constitue. La structure monolithique comprend une couche 110 déposée sur les surfaces libres de premier type 210 et sur les surfaces libres de deuxième type 220, voire également sur les surfaces libres de troisième type 230, afin de constituer l'une des jonctions dopées des diodes électroluminescentes 11, 12, 13. Par exemple, la couche 110 est dopée de sorte à constituer un semiconducteur dopé n. Il peut s'agir de nitrure de gallium dopé avec du silicium ou de nitrure d'indium et de gallium (InGaN). Une couche 111 de matériau actif est ensuite déposée sur la couche 110, typiquement à base de InGaN. Puis une couche 112 est déposée sur la couche 111 pour constituer l'autre jonction dopée des diodes électroluminescentes. Par exemple, la couche 112 est dopée de sorte à constituer un semiconducteur dopé p. Il peut s'agir de nitrure de gallium dopé avec du magnésium par exemple. Ces couches 110, 112 et 112 constituent des diodes électroluminescentes 11, 12, 13 respectivement au niveau des premières parties 21, des deuxièmes parties 22 et des éventuelles troisièmes parties 23 de la structure tampon 2 du pseudo-substrat 10.

Dans la présente solution, par la nature des surfaces libres de premier type 210 et des surfaces libres de deuxième type 220, voire par la nature des surfaces libres de troisième type 230, les diodes électroluminescentes 11, 12, 13 qui sont pourtant formées à partir d'une seule procédure de formation commune pour l'ensemble du dispositif optoélectronique 100, sont aptes à émettre des lumières L1, L2 et L3 à des longueurs d'onde différentes, notamment situées dans les couleurs bleues, les couleurs rouges et les couleurs vertes, et ce sans avoir besoin de convertisseurs de couleurs. Le rendement lumineux est très élevé et la fabrication est simple et économique.

Pour parvenir à la fabrication d'un pseudo-substrat 10 dont les principes ont été exposés ci-avant, par exemple illustré à la figure 1 ou à la figure 11, il est nécessaire de mettre en œuvre au moins les étapes générales suivantes :
- une première étape de fourniture du substrat 1,
- une deuxième étape de formation de la couche 211 formée en GaN massif sur la face supérieure la du substrat 1,
- une troisième étape de formation de l'empilement 221 qui alterne des couches d'InGaN et des couches intermédiaires de GaN et dans lequel l'indium est présent dans la première proportion massique, sur la couche 211 de GaN massif qui résulte de la deuxième étape et/ou sur la face supérieure la du substrat 1.

Le procédé peut ensuite comprendre une quatrième étape de formation de l'empilement 231 qui alterne des couches de InGaN et des couches intermédiaires de GaN et dans lequel l'indium est présent dans la deuxième proportion massique, sur la couche 211 de GaN massif résultant de la deuxième étape et/ou sur l'empilement 221 résultant de la troisième étape.

Il va maintenant être décrit deux modes d'exécution différents de ce procédé de fabrication général.

Ainsi, les figures 3 à 7 représentent différentes étapes successives du premier mode d'exécution d'un procédé de fabrication du pseudo-substrat 10.

La figure 3 représente l'étape de fourniture du substrat 1, disposant de la face supérieure la adaptée à la formation, sur celle-ci, de la structure tampon 2. L'étape de fourniture du substrat 1 peut comprendre toute les étapes connues de l'Homme du Métier à cet effet (nettoyage de la face la, rectification mécanique ou chimique de la face la etc....). Il peut également être prévu la formation d'une couche de nucléation entre le substrat 1 et la structure tampon 2 proprement dite.

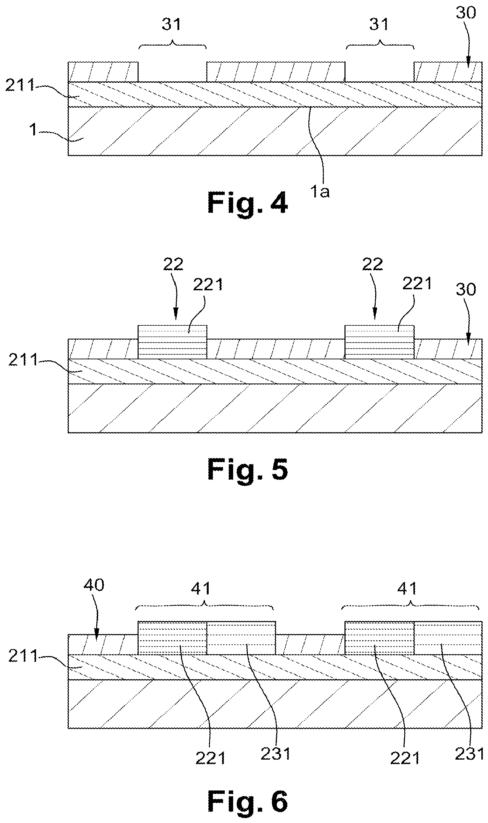

De manière générale dans ce premier mode d'exécution du procédé de fabrication du pseudo-substrat 10, en référence à la figure 5, la troisième étape comprend des étapes successives de dépôt de couches d'InGaN et de couches intermédiaires de GaN dans des ouvertures 31 délimitées par un premier masque 30 recouvrant la couche 211 de GaN massif résultant de la deuxième étape.

La figure 4 illustre la situation intermédiaire dans laquelle le premier masque 30 recouvre partiellement la couche 211 de GaN massif, avant la mise en œuvre des étapes successives de dépôt des couches d'InGaN et de couches intermédiaires de GaN. Dans l'exemple tel qu'illustré, cela étant non limitatif, les ouvertures 31 du premier masque 30 correspondent aux deuxièmes parties 22 de la structure tampon 2, en définissant les surfaces libres de deuxième type 220 après le retrait du premier masque 30.

Puis, dans le premier mode d'exécution du procédé de fabrication, la quatrième étape comprend (figure 6) des étapes successives de dépôt de couches d'InGaN et de couches intermédiaires de GaN dans tout ou partie de la surface d'ouvertures 41 d'un deuxième masque 40 recouvrant au moins la couche 211 de GaN massif qui résulte de la deuxième étape. Dans l'exemple tel qu'illustré, cela étant non limitatif, le deuxième masque 40 recouvre exactement les zones de la couche 211 sous-jacente qui sont destinées à constituer, à l'issue du procédé de fabrication et après retrait du deuxième masque 40, les surfaces libres du premier type 210. Les ouvertures 41 englobent à la fois les deuxièmes parties 22 et les troisièmes parties 23 de la structure tampon 2. Il pourra être veillé à déposer les couches successives de l'empilement 231 dans les ouvertures 41 du deuxième masque 40 uniquement au niveau de la zone de celles-ci où l'empilement 221 précédemment formé via le premier masque 30 n'est pas présent.

La figure 7 représente la situation après le retrait du deuxième masque 40. Les caractéristiques du pseudo-substrat 10 ainsi obtenu sont identiques à celles du pseudo-substrat 10 illustré sur la figure 1, à la différence qu'il existe un décalage D entre les surfaces libres de premier type 210 d'une part, et les surfaces libres de deuxième type 220 et de troisième type 230 d'autre part, suivant une direction perpendiculaire au plan général P. Cette disposition découle du fait qu'ici les empilements 221 et 231 sont formés sur la couche 211 de GaN massif, ce qui n'est pas le cas dans le pseudo-substrat 10 du mode de réalisation de la figure 1.

Les figures 8 et 9 représentent ensuite différentes étapes successives du deuxième mode d'exécution du procédé de fabrication du pseudo-substrat 10.

De manière générale dans ce deuxième mode d'exécution du procédé de fabrication du pseudo-substrat 10, la troisième étape comprend (figure 8) :
- un premier ensemble d'étapes successives de dépôt de couches d'InGaN et de couches intermédiaires de GaN sur toute la surface de la couche 211 de GaN massif qui résulte de la deuxième étape, formant un empilement repéré 50,
- puis une première étape de gravure (figure 9) symbolisée par le repère G1, à travers l'empilement 50 qui résulte de ce premier ensemble d'étapes successives de dépôt d'InGaN/GaN.

Cette première étape de gravure G1 est réalisée de sorte à rendre libres des surfaces déterminées de la couche 211 de GaN massif, ces surfaces ainsi rendues libres par gravure correspondant aux surfaces libres de premier type 210 de ladite au moins une première partie 21 de la structure tampon 2. Ainsi, les zones où la première gravure G1 est réalisée correspondent aux premières parties 21 de la structure tampon 2 du pseudo-substrat 10. Dans ces zones, la face supérieure de la couche 211 sous-jacente en GaN massif devient une surface libre adaptée à une croissance ultérieure de diodes électroluminescentes 11.

Puis, dans le deuxième mode d'exécution du procédé de fabrication, la quatrième étape comprend :
- un deuxième ensemble d'étapes successives de dépôt de couches d'InGaN et de couches intermédiaires de GaN sur toute la surface de l'empilement 50 qui résulte lui-même du premier ensemble d'étapes successives de dépôt, formant un empilement repéré 60 (figure 8),
- puis une deuxième étape de gravure (figure 9) symbolisée par le repère G2, à travers l'empilement 60 qui résulte du deuxième ensemble d'étapes successives de dépôt d'InGaN/GaN.

Cette deuxième étape de gravure G2 est réalisée de sorte à rendre libres des surfaces déterminées de l'empilement 50 qui résulte du premier ensemble d'étapes successives de dépôt. Ces surfaces de l'empilement 50 ainsi rendues libres correspondent aux surfaces libres de deuxième type 220 de ladite au moins une deuxième partie 22 de la structure tampon 2.

La première gravure G1 peut être réalisée par toute technique connue et adaptée, par exemple par voie mécanique ou chimique. Il en est de même pour la deuxième gravure G2.

La figure 9 représente ainsi le pseudo-substrat 10 obtenu à la suite des deux gravures G1, G2.

La partie de l'empilement 50 non gravée à la première gravure G1 et non recouverte par de l'empilement 60 constitue en pratique l'empilement 221 défini précédemment pour chaque deuxième partie 21. Les zones où la deuxième gravure G2 est réalisée mais où la première gravure G1 n'est pas réalisée correspondent aux deuxièmes parties 22 de la structure tampon 2 du pseudo-substrat 10. Dans ces zones, la face supérieure de l'empilement 50 devient une surface libre adaptée à une croissance ultérieure de diodes électroluminescentes 12.

La partie de l'empilement 60 non gravée à la deuxième gravure G2 constitue en pratique l'empilement 231 défini précédemment pour chaque troisième partie 23. Les zones où la deuxième gravure G2 n'est pas réalisée, ni la première gravure G1, correspondent aux troisièmes parties 23 de la structure tampon 2 du pseudo-substrat 10. Dans ces zones, la face supérieure de l'empilement 60 est une surface libre adaptée à une croissance ultérieure de diodes électroluminescentes 13.

Les figures 8 et 9 représentent le cas particulier dans lequel le deuxième ensemble d'étapes de dépôt, aboutissant à la formation de l'empilement repéré 60, est réalisé avant la mise en œuvre de la première gravure G1. Cette disposition rend le procédé de fabrication plus simple d'exécution mais sans que cela ne soit limitatif. Il peut tout à fait être envisagé, en variante, que la première gravure G1 soit réalisée à travers l'empilement 50 avant que le deuxième ensemble d'étapes de dépôt qui aboutit à l'empilement 60 ne soit réalisé.

Par ailleurs, dans le cas où le deuxième ensemble d'étapes de dépôt, aboutissant à la formation de l'empilement repéré 60, est réalisé avant la mise en œuvre de la première gravure G1 (aboutissant à la situation de la figure 8), il est possible de réaliser la première gravure G1 avant de réaliser la deuxième gravure G2, ou inversement de réaliser la deuxième gravure G2 avant de réaliser la première gravure G1.

Pour parvenir à l'obtention d'un dispositif optoélectronique 100 dont les principes ont été exposés ci-avant, par exemple illustré à la figure 2 ou à la figure 11, il est nécessaire de mettre en œuvre au moins une première phase de fourniture du pseudo-substrat 10 par mise en œuvre du procédé de fabrication précédemment décrit, puis une deuxième phase de formation :
- d'au moins une diode électroluminescente 11 par croissance sur chaque surface libre du premier type 210 de ladite au moins une première partie 21 de la structure tampon 2 du pseudo-substrat 10 fourni à la première phase, cette diode électroluminescente 11 étant apte à émettre de la lumière L1 à la première longueur d'onde,
- et d'au moins une diode électroluminescente 12 par croissance sur chaque surface libre du deuxième type 220 de ladite au moins une deuxième partie 22 de la structure tampon 2 du pseudo-substrat 10 fourni à la première phase, cette diode électroluminescente 12 étant apte à émettre de la lumière L2 à la deuxième longueur d'onde qui est différente de la première longueur d'onde.

Le procédé d'obtention du dispositif optoélectronique 100 peut ensuite comprendre une troisième phase optionnelle de formation d'au moins une diode électroluminescente 13 par croissance sur chaque surface libre du troisième type 230 de ladite au moins une troisième partie 23 de la structure tampon 2 du pseudo-substrat 10 fourni à la première phase. Cette diode électroluminescente 13 est notamment apte à émettre de la lumière L3 à la troisième longueur d'onde différente des première et deuxième longueurs d'onde respectivement des lumières L1 et L2.

Comme cela a déjà été indiqué précédemment, différentes techniques de formation des diodes électroluminescentes 11, 12, 13 peuvent être envisagées.

Ainsi selon une premier mode d'exécution envisageable (figure 10), chaque diode électroluminescente 11, 12, 13 est formée sur la base d'éléments tridimensionnels semiconducteurs, eux-mêmes au moins partiellement obtenus par croissance par épitaxie à partir des surfaces libres 210, 220, 230. Les diodes électroluminescentes 11, 12, 13 sont donc formées à base d'un matériau semiconducteur de type composé III-V, notamment le nitrure de gallium (GaN), le nitrure d'indium et de gallium (InGaN) ou le nitrure d'aluminium et de gallium (AIGaN). Typiquement, chaque diode électroluminescente 11, 12, 13 formée à la deuxième phase et à la troisième phase peut comprendre des nano-éléments semiconducteurs tridimensionnels, préférentiellement en InGaN ou en GaN dopé, de forme filaire, conique ou tronconique, formés par épitaxie à partir des surfaces libres de premier type 210, des surfaces libres de deuxième type 220 et des surfaces libres de troisième type 230. Ces techniques sont classiques pour l'Homme du Métier qui saura aisément les adapter au cas d'espèce.

Selon un deuxième mode d'exécution envisageable (en référence à la figure 2 par exemple), les diodes électroluminescentes 11, 12, 13 sont formées sous la forme d'une structure monolithique formée sur la structure tampon 2 du côté opposé au substrat 1, cette structure monolithique étant apte à émettre de la lumière polychrome à partir des diodes électroluminescentes 11, 12, 13 qu'elle constitue. La deuxième phase de formation des diodes électroluminescentes 11, 12 sur les surfaces libres de premier type 210 et sur les surfaces libres de deuxième type 220 et la troisième phase de formation des diodes électroluminescentes sur les surfaces libres de troisième type 230, peuvent notamment comprendre :
- une étape de dépôt d'une couche 110 sur les surfaces libres de premier type 210 et sur les surfaces libres de deuxième type 220, voire sur les surfaces libres de troisième type 230, afin de constituer l'une des jonctions dopées des diodes électroluminescentes 11, 12, 13 ; par exemple la couche 110 est dopée de sorte à constituer un matériau semiconducteur dopé n. Il peut s'agir de nitrure de gallium dopé avec du silicium ou de l'InGaN.
- une étape de dépôt d'une couche 111 de matériau actif, par exemple par croissance épitaxiale, sur la couche 110, le matériau actif étant typiquement à base de nitrure d'indium et de gallium.
- une étape de dépôt, sur la couche 111, d'une couche 112 de matériau actif pour constituer l'autre jonction dopée des diodes électroluminescentes 11, 12, 13 ; par exemple la couche 112 est dopée de sorte à constituer un semiconducteur dopé p. Il peut s'agir de nitrure de gallium dopé avec du magnésium par exemple.

Cet empilement des couches 110, 112 et 112 constitue des diodes électroluminescentes 11, 12, 13 respectivement au niveau des premières parties 21, des deuxièmes parties 22 et des éventuelles troisièmes parties 23 de la structure tampon 2 du pseudo-substrat 10.

Par la nature des surfaces libres de premier type 210, des surfaces libres de deuxième type 220 et des surfaces libres de troisième type 230, les diodes électroluminescentes 11, 12, 13 formées sur celles-ci sont aptes à émettre des lumières L1, L2, L3 à des longueurs d'ondes différentes, bien que les étapes de formation des diodes électroluminescentes 11, 12, 13 soient identiques pour l'ensemble du dispositif optoélectronique 100. Il en résulte, une fois encore, une simplicité de fabrication et une réduction des coûts pour la fabrication d'écrans d'affichage ou de systèmes de projection d'images sur la base de tels dispositifs optoélectroniques 100. Le rendement lumineux est supérieur aux solutions actuelles et on s'affranchit du besoin de former des convertisseurs de couleur sous la forme de plots photoluminescents.

Bien entendu, l'invention n'est pas limitée aux modes de réalisation représentés et décrits ci-avant, mais est définie par les revendications attenantes.

## Revendications

1. Pseudo-substrat (10) pour dispositif optoélectronique (100), le pseudo-substrat (10) étant adapté à la croissance de diodes électroluminescentes (11, 12, 13) sur le pseudo-substrat (10), le pseudo-substrat (10) comprenant un substrat (1) et une structure tampon (2) formée sur une face supérieure (1a) du substrat (1), la structure tampon (2) comprenant :
- au moins une première partie (21) où une couche (211) formée en nitrure de gallium (GaN) massif délimite au moins une surface libre d'un premier type (210) tournée du côté opposé à la face supérieure (1a) du substrat (1), chaque surface libre du premier type (210) étant adaptée à la croissance sur celle-ci d'au moins une diode électroluminescente (11) majoritairement à base d'un composé III-V apte à émettre de la lumière (L1) à une première longueur d'onde,
- et au moins une deuxième partie (22) où un empilement (221) alternant des couches de nitrure d'indium et de gallium (InGaN) et des couches intermédiaires de GaN et dans lequel l'indium est présent dans une première proportion massique, délimite au moins une surface libre d'un deuxième type (220) tournée du côté opposé à la face supérieure (1a) du substrat (1), chaque surface libre du deuxième type (220) étant adaptée à la croissance sur celle-ci d'au moins une diode électroluminescente (12) majoritairement à base d'un composé III-V apte à émettre de la lumière (L2) à une deuxième longueur d'onde différente de la première longueur d'onde,
- ladite au moins une deuxième partie (22) de la structure tampon (2) étant décalée par rapport à ladite au moins une première partie (21) de la structure tampon (2) dans un plan général (P) orienté parallèlement au plan de la face supérieure (1a) du substrat (1).

2. Pseudo-substrat (10) selon la revendication 1, **caractérisé en ce qu'**au niveau de ladite au moins une deuxième partie (22) de la structure tampon (2), l'empilement (221) alternant des couches de InGaN et des couches intermédiaires de GaN est au moins partiellement formé sur la face supérieure (1a) du substrat (1), **en ce qu'**il comprend une couche de nucléation formée sur la face supérieure (1a) du substrat (1) et **en ce qu'**au niveau de ladite au moins une deuxième partie (22) de la structure tampon (2), l'empilement (221) alternant des couches de InGaN et des couches intermédiaires de GaN est au moins partiellement formé sur la couche de nucléation.

3. Pseudo-substrat (10) selon la revendication 2, **caractérisé en ce que** l'empilement (221) alternant des couches de InGaN et des couches intermédiaires de GaN de ladite au moins une deuxième partie (22) se présente sous la forme d'au moins un nano-élément en forme de fil ou en forme de pyramide.

4. Pseudo-substrat (10) selon l'une quelconque des revendications 1 à 3, **caractérisé en ce que** la structure tampon (2) comprend au moins une troisième partie (23) où un empilement (231) alternant des couches de InGaN et des couches intermédiaires de GaN et dans lequel l'indium est présent dans une deuxième proportion massique strictement différente de la première proportion massique, délimite au moins une surface libre d'un troisième type (230) tournée du côté opposé à la face supérieure (1a) du substrat (1), chaque surface libre du troisième type (230) étant adaptée à la croissance sur celle-ci d'au moins une diode électroluminescente (13) majoritairement à base d'un composé III-V apte à émettre de la lumière (L3) à une troisième longueur d'onde différente de la première longueur d'onde et de la deuxième longueur d'onde, et **en ce que** ladite au moins une troisième partie (23) de la structure tampon (2) est décalée par rapport à ladite au moins une première partie (21) de la structure tampon (2) et par rapport à ladite au moins une deuxième partie (22) de la structure tampon (2) dans le plan général (P) orienté parallèlement au plan de la face supérieure (1a) du substrat (1).

5. Pseudo-substrat (10) selon la revendication 4, **caractérisé en ce qu'**au niveau de ladite au moins une troisième partie (23) de la structure tampon (2), l'empilement (231) alternant des couches de InGaN et des couches intermédiaires de GaN est au moins partiellement formé sur la face supérieure (1a) du substrat (1), **en ce qu'**il comprend une couche de nucléation formée sur la face supérieure (1a) du substrat (1) et **en ce qu'**au niveau de ladite au moins une troisième partie (23) de la structure tampon (2), l'empilement (231) alternant des couches de InGaN et des couches intermédiaires de GaN est au moins partiellement formé sur la couche de nucléation.

6. Pseudo-substrat (10) selon l'une quelconque des revendications 4 ou 5, **caractérisé en ce que** l'empilement (231) alternant des couches de InGaN et des couches intermédiaires de GaN de ladite au moins une troisième partie (23) se présente sous la forme d'au moins un nano-élément en forme de fil ou en forme de pyramide.

7. Pseudo-substrat (10) selon l'une quelconque des revendications 4 à 6, **caractérisé en ce que** la deuxième proportion massique de l'indium au niveau de ladite au moins une troisième partie (23) est incluse dans une plage entre 5 et 25%, préférentiellement entre 10 et 20%.

8. Pseudo-substrat (10) selon l'une quelconque des revendications 1 à 7, **caractérisé en ce que** la première proportion massique de l'indium au niveau de ladite au moins une deuxième partie (22) est incluse dans une plage entre 5 et 25%, préférentiellement entre 10 et 20%.

9. Dispositif optoélectronique (100) comprenant un pseudo-substrat (10) selon l'une quelconque des revendications 1 à 8 et :
- au moins une diode électroluminescente (11) majoritairement à base d'un composé III-V formée par croissance sur la surface libre du premier type (210) de ladite au moins une première partie (21) de la structure tampon (2) du pseudo-substrat (10) et apte à émettre de la lumière (L1) à la première longueur d'onde,
- au moins une diode électroluminescente (12) majoritairement à base d'un composé III-V formée par croissance sur la surface libre du deuxième type (220) de ladite au moins une deuxième partie (22) de la structure tampon (2) du pseudo-substrat (10) et apte à émettre de la lumière (L2) à la deuxième longueur d'onde différente de la première longueur d'onde.

10. Dispositif optoélectronique (100) selon la revendication 9, **caractérisé en ce que** le pseudo-substrat (10) étant selon l'une quelconque des revendications 4 à 7, ou selon la revendication 8 et l'une quelconque des revendications 4 à 7, le dispositif optoélectronique (100) comprend au moins une diode électroluminescente (13) majoritairement à base d'un composé III-V formée par croissance sur la surface libre du troisième type (230) de ladite au moins une troisième partie (23) de la structure tampon (2) du pseudo-substrat (10) et apte à émettre de la lumière (L3) à la troisième longueur d'onde différente de la première longueur d'onde et de la deuxième longueur d'onde.

11. Procédé de fabrication d'un pseudo-substrat (10) selon l'une quelconque des revendications 1 à 8, **caractérisé en ce qu'**il comprend une première étape de fourniture du substrat (1), une deuxième étape de formation de la couche (211) formée en GaN massif sur la face supérieure (1a) du substrat (1), une troisième étape de formation de l'empilement (221) alternant des couches de InGaN et des couches intermédiaires de GaN et dans lequel l'indium est présent dans la première proportion massique, sur la couche (211) résultant de la deuxième étape et/ou sur la face supérieure (1a) du substrat (1).

12. Procédé de fabrication d'un pseudo-substrat (10) selon la revendication 11, **caractérisé en ce que** la troisième étape comprend des étapes successives de dépôt de couches d'InGaN et de couches intermédiaires de GaN dans des ouvertures (31) délimitées par un premier masque (30) recouvrant la couche (211) de GaN massif résultant de la deuxième étape.

13. Procédé de fabrication d'un pseudo-substrat (10) selon la revendication 11, **caractérisé en ce que** la troisième étape comprend un premier ensemble d'étapes successives de dépôt de couches d'InGaN et de couches intermédiaires de GaN sur toute la surface de la couche (211) résultant de la deuxième étape, puis une première étape de gravure (G1) à travers un empilement (50) qui résulte dudit premier ensemble d'étapes successives de dépôt, ladite première étape de gravure (G1) étant réalisée de sorte à rendre libres des surfaces déterminées de la couche (211) qui résulte de la deuxième étape, lesdites surfaces rendues libres correspondant aux surfaces libres de premier type (210) de ladite au moins une première partie (21) de la structure tampon (2).

14. Procédé de fabrication d'un pseudo-substrat (10) selon l'une quelconque des revendications 11 à 13, **caractérisé en ce que** le pseudo-substrat (10) étant selon l'une quelconque des revendications 4 à 7, ou selon la revendication 8 et l'une quelconque des revendications 4 à 7, le procédé comprend une quatrième étape de formation de l'empilement (231) alternant des couches de InGaN et des couches intermédiaires de GaN et dans lequel l'indium est présent dans la deuxième proportion massique, sur la couche (211) résultant de la deuxième étape et/ou sur l'empilement (221) résultant de la troisième étape.

15. Procédé de fabrication d'un pseudo-substrat (10) selon la revendication 14, **caractérisé en ce que** la quatrième étape comprend des étapes successives de dépôt de couches d'InGaN et de couches intermédiaires de GaN dans tout ou partie de la surface d'ouvertures (41) d'un deuxième masque (40) recouvrant au moins la couche (211) de GaN massif qui résulte de la deuxième étape.

16. Procédé de fabrication d'un pseudo-substrat (10) selon les revendications 13 et 14, **caractérisé en ce que** la quatrième étape comprend un deuxième ensemble d'étapes successives de dépôt de couches d'InGaN et de couches intermédiaires de GaN sur toute la surface de l'empilement (50) résultant du premier ensemble d'étapes successives de dépôt, puis une deuxième étape de gravure (G2) à travers un empilement (60) qui résulte dudit deuxième ensemble d'étapes successives de dépôt, ladite deuxième étape de gravure étant réalisée de sorte à rendre libres des surfaces déterminées de l'empilement (50) qui résulte du premier ensemble d'étapes successives de dépôt, lesdites surfaces rendues libres correspondant aux surfaces libres de deuxième type (220) de ladite au moins une deuxième partie (22) de la structure tampon (2).

## Patentansprüche

1. Pseudosubstrat (10) für eine optoelektronische Vorrichtung (100), wobei das Pseudosubstrat (10) für das Wachstum von Leuchtdioden (11, 12, 13) auf dem Pseudosubstrat (10) geeignet ist, wobei das Pseudosubstrat (10) ein Substrat (1) und eine auf einer oberen Oberfläche (1a) des Substrats (1) gebildete Pufferstruktur (2) umfasst, wobei die Pufferstruktur (2) umfasst:
- mindestens einen ersten Teil (21), in dem eine aus massivem Galliumnitrid (GaN) gebildete Schicht (211) mindestens eine freie Oberfläche eines ersten Typs (210) begrenzt, die auf die der oberen Oberfläche (1a) des Substrats (1) gegenüberliegende Seite gedreht ist, wobei jede freie Oberfläche des ersten Typs (210) an das Wachstum mindestens einer Leuchtdiode (11) darauf geeignet ist, überwiegend auf der Grundlage einer Zusammensetzung III-V, die zum Ausgeben des Lichts (L1) in einer ersten Wellenlänge geeignet ist,
- und mindestens einen zweiten Teil (22), in dem ein abwechselnder Stapel (221) aus Schichten aus Indium- und Galliumnitrid (InGaN) und aus Zwischenschichten aus GaN, und in dem das Indium in einem ersten Masseanteil vorahnden ist, mindestens eine freie Fläche eines zweiten Typs (220) begrenzt, die auf die der oberen Oberfläche (1a) des Substrats (1) gegenüberliegende Seite gedreht ist, wobei jede freie Oberfläche vom zweiten Typ (220) an das Wachstum mindestens einer Leuchtdiode (12) darauf geeignet ist, überwiegend auf der Grundlage einer Zusammensetzung III-V, die zum Ausgeben des Lichts (L2) in einer von der ersten Wellenlänge unterschiedlichen zweiten Wellenlänge geeignet ist,
- wobei der mindestens eine zweite Teil (22) der Pufferstruktur (2) bezüglich des mindestens ersten Teils (21) der Pufferstruktur (2) in einer allgemeinen Ebene (P), die parallel zur Ebene der oberen Oberfläche (1a) des Substrats (1) ausgerichtet ist, verschoben ist.

2. Pseudosubstrat (10) nach Anspruch 1, **dadurch gekennzeichnet, dass** im Bereich des mindestens einen zweiten Teils (22) der Pufferstruktur (2) der abwechselnde Stapel (221) aus InGaN-Schichten und Zwischenschichten aus GaN mindestens teilweise auf der oberen Oberfläche (1a) des Substrats (1) gebildet ist, und dass er eine Keimbildungsschicht umfasst, die auf der oberen Oberfläche (1a) des Substrats (1) gebildet ist, und dass im Bereich des mindestens einen zweiten Teils (22) der Pufferstruktur (2) der abwechselnde Stapel (221) der InGaN-Schichten und Zwischenschichten aus GaN mindestens teilweise auf der Keimbildungsschicht gebildet ist.

3. Pseudosubstrat (10) nach Anspruch 2, **dadurch gekennzeichnet, dass** der abwechselnde Stapel (221) aus InGaN-Schichten und Zwischenschichten aus GaN des mindestens einen zweiten Teils (22) sich in der Form mindestens eines Nanoelements in Fadenform oder in Pyramidenform darstellt.

4. Pseudosubstrat (10) nach einem der Ansprüche 1 bis 3, **dadurch gekennzeichnet, dass** die Pufferstruktur (2) mindestens einen dritten Teil (23) umfasst, in dem ein abwechselnder Stapel (231) aus InGaN-Schichten und Zwischenschichten und in dem das Indium in einem zweiten Masseanteil, der sich vom ersten Masseanteil strikt unterscheidet, mindestens eine freie Oberfläche eines dritten Typs (230) begrenzt, die auf die der oberen Oberfläche (1a) des Substrats (1) gegenüberliegende Seite gedreht ist, wobei jede Oberfläche des dritten Typs (230) an das Wachstum von mindestens einer Leuchtdiode (13) darauf geeignet ist, überwiegend auf der Grundlage einer Zusammensetzung III-V, die zum Ausgeben des Lichts (L3) in einer von der ersten Wellenlänge und der zweiten Wellenlänge unterschiedlichen dritten Wellenlänge geeignet ist, und dass der mindestens eine dritte Teil (23) der Pufferstruktur (2) bezüglich des mindestens einen ersten Teils (21) der Pufferstruktur (2) und bezüglich des mindestens einen zweiten Teils (22) der Pufferstruktur (2) in der allgemeinen Ebene (P), die parallel zur Ebene der oberen Oberfläche (1a) des Substrats (1) ausgerichtet ist, verschoben ist.

5. Pseudosubstrat (10) nach Anspruch 4, **dadurch gekennzeichnet, dass** im Bereich des mindestens einen dritten Teils (23) der Pufferstruktur (2) der abwechselnde Stapel (231) aus InGaN-Schichten und Zwischenschichten aus GaN mindestens teilweise auf der oberen Oberfläche (1a) des Substrats (1) gebildet ist, und dass er eine auf der oberen Oberfläche (1a) des Substrats (1) gebildete Keimbildungsschicht umfasst, und dass im Bereich des mindestens einen dritten Teils (23) der Pufferstruktur (2) der abwechselnde Stapel (231) aus InGaN-Schichten und Zwischenschichten aus GaN mindestens teilweise auf der Keimbildungsschicht gebildet ist.

6. Pseudosubstrat (10) nach einem der Ansprüche 4 oder 5, **dadurch gekennzeichnet, dass** der abwechselnde Stapel (231) aus InGaN-Schichten und Zwischenschichten aus GaN des mindestens einen dritten Teils (23) sich in der Form mindestens eines Nanoelements in Fadenform oder in Pyramidenform darstellt.

7. Pseudosubstrat (10) nach einem der Ansprüche 4 bis 6, **dadurch gekennzeichnet, dass** der zweite Masseanteil des Indiums im Bereich des mindestens einen dritten Teils (23) in einem Bereich zwischen 5 und 25 %, vorzugsweise zwischen 10 und 20 % umfasst ist.

8. Pseudosubstrat (10) nach einem der Ansprüche 1 bis 7, **dadurch gekennzeichnet, dass** der erste Masseanteil des Indiums im Bereich des mindestens einen zweiten Teils (22) in einem Bereich zwischen 5 und 25 %, vorzugsweise zwischen 10 und 20 % liegt.

9. Optoelektronische Vorrichtung (100), umfassend ein Pseudosubstrat (10) nach einem der Ansprüche 1 bis 8 und:
- mindestens eine Leuchtdiode (11) überwiegend auf der Grundlage einer Zusammensetzung III-V, die zum Wachstum auf der freien Oberfläche des ersten Typs (210) des mindestens einen ersten Teils (21) der Pufferstruktur (2) des Pseudosubstrats (10) gebildet und zum Ausgeben des Lichts (L1) in der ersten Wellenlänge geeignet ist,
- mindestens eine Leuchtdiode (12) überwiegend auf der Grundlage einer Zusammensetzung III-V, die zum Wachstum auf der freien Oberfläche des zweiten Typs (220) des mindestens einen zweiten Teils (22) der Pufferstruktur (2) des Pseudosubstrats (10) gebildet und zum Ausgeben des Lichts (L2) in der von der ersten Wellenlänge unterschiedlichen zweiten Wellenlänge geeignet ist.

10. Optoelektronische Vorrichtung (100) nach Anspruch 9, **dadurch gekennzeichnet, dass** das Pseudosubstrat (10) nach einem der Ansprüche 4 bis 7 oder nach Anspruch 8 und einem der Ansprüche 4 bis 7 ist, die optoelektronische Vorrichtung (100) mindestens eine Leuchtdiode (13), überwiegend auf Basis einer Zusammensetzung III-V umfasst, die durch Wachstum auf der freien Oberfläche des dritten Typs (230) des mindestens einen dritten Teils (23) der Pufferstruktur (2) des Pseudosubstrats (10) gebildet und geeignet ist, das Licht (L3) in der von der ersten Wellenlänge und der zweiten Wellenlänge unterschiedlichen dritten Wellenlänge auszugeben.

11. Verfahren zum Herstellen eines Pseudosubstrats (10) nach einem der Ansprüche 1 bis 8, **dadurch gekennzeichnet, dass** es einen ersten Schritt des Bereitstellens des Substrats (1), einen zweiten Schritt des Bildens der aus massivem GaN gebildeten Schicht (211) auf der oberen Oberfläche (1a) des Substrats (1), einen dritten Schritt des Bildens des Stapels (221) aus abwechselnden InGaN-Schichten und Zwischenschichten aus GaN, und in dem das Indium im ersten Masseanteil vorliegt, auf der aus dem zweiten Schritt resultierenden Schicht (211) und/oder auf der oberen Oberfläche (1a) des Substrats (1) umfasst.

12. Verfahren zum Herstellen eines Pseudosubstrats (10) nach Anspruch 11, **dadurch gekennzeichnet, dass** der dritte Schritt aufeinanderfolgende Schritte der Abscheidung von InGaN-Schichten und von Zwischenschichten aus GaN in Öffnungen (31), die durch eine die aus dem zweitem Schritt resultierende Schicht (211) aus massivem GaN bedeckende erste Maske (30) begrenzt werden.

13. Verfahren zum Herstellen eines Pseudosubstrats (10) nach Anspruch 11, **dadurch gekennzeichnet, dass** der dritte Schritt eine erste Gruppe von aufeinanderfolgenden Schritten der Abscheidung von InGaN-Schichten und Zwischenschichten aus GaN auf der gesamten Oberfläche der aus dem zweiten Schritt resultierenden Schicht (211), dann einen ersten Gravurschritt (G1) durch einen Stapel (50), der aus der ersten Gruppe von aufeinanderfolgenden Abscheidungsschritten resultiert, umfasst, wobei der erste Gravurschritt (G1) so ausgeführt wird, dass bestimmte Oberflächen der aus dem zweiten Schritt resultierenden Schicht (211) freigelegt werden, wobei die freigelegten Oberflächen den freien Oberflächen des ersten Typs (210) des mindestens ersten Teils (21) der Pufferstruktur (2) entsprechen.

14. Verfahren zum Herstellen eines Pseudosubstrats (10) nach einem der Ansprüche 11 bis 13, **dadurch gekennzeichnet, dass** das Pseudosubstrat (10) nach einem der Ansprüche 4 bis 7 oder nach Anspruch 8 und einem der Ansprüche 4 bis 7 ist, das Verfahren einen vierten Schritt des Bildens des Stapels (231) aus abwechselnden InGaN-Schichten und Zwischenschichten aus GaN, und in dem das Indium im zweiten Masseanteil vorliegt, auf der aus dem zweiten Schritt resultierenden Schicht (211) und/oder auf dem aus dem dritten Schritt resultierenden Stapel (221) umfasst.

15. Verfahren zum Herstellen eines Pseudosubstrats (10) nach Anspruch 14, **dadurch gekennzeichnet, dass** der vierte Schritt aufeinanderfolgende Schritte zur Abscheidung von InGaN-Schichten und Zwischenschichten aus GaN in der gesamten Oberfläche oder einem Teil der Oberfläche der Öffnungen (41) einer zweiten Maske (40) umfasst, die mindestens die aus dem zweiten Schritt resultierende massive GaN-Schicht (211) abdeckt.

16. Verfahren zum Herstellen eines Pseudosubstrats (10) nach Ansprüchen 13 und 14, **dadurch gekennzeichnet, dass** der vierte Schritt eine zweite Gruppe von aufeinanderfolgenden Schritten der Abscheidung von InGaN-Schichten und Zwischenschichten aus GaN auf der gesamten Oberfläche des aus der ersten Schrittgruppe resultierenden Stapels (50), dann einen zweiten Gravurschritt (G2) durch einen Stapel (60), der aus der zweiten Gruppe von aufeinanderfolgenden Abscheidungsschritten resultiert, umfasst, wobei der zweite Gravurschritt so ausgeführt wird, dass bestimmte Oberflächen des aus der ersten Gruppe von aufeinanderfolgenden Abscheidungsschritten resultierenden Stapels (50) freigelegt werden, wobei die freigelegten Oberflächen den freien Oberflächen des zweiten Typs (220) des mindestens zweiten Teils (22) der Pufferstruktur (2) entsprechen.

## Claims

1. A pseudo-substrate (10) for an optoelectronic device (100), the pseudo-substrate (10) being suitable for the growth of light-emitting diodes (11, 12, 13) on the pseudo-substrate (10), the pseudo-substrate (10) comprising a substrate (1) and a buffer structure (2) formed on an upper face (1a) of the substrate (1), the buffer structure (2) comprising:
- at least one first portion (21) where a layer (211) formed of bulk gallium nitride (GaN) delimits at least one free surface of a first type (210) turned on the side opposite to the upper face (1a) of the substrate (1), each free surface of the first type (210) being suitable for the growth thereon of at least one light-emitting diode (11) mainly based on a III-V compound capable of emitting light (L1) at a first wavelength,
- and at least one second portion (22) where a stack (221) alternating layers of indium and gallium nitride (InGaN) and intermediate layers of GaN and wherein the indium is present in a first mass proportion, delimits at least one free surface of a second type (220) turned on the side opposite to the upper face (1a) of the substrate (1), each free surface of the second type (220) being suitable for the growth thereon of at least one light-emitting diode (12) mainly based on a III-V compound capable of emitting light (L2) at a second wavelength different from the first wavelength,
- said at least one second portion (22) of the buffer structure (2) being offset with respect to said at least one first portion (21) of the buffer structure (2) in a general plane (P) oriented parallel to the plane of the upper face (1a) of the substrate (1).

2. The pseudo-substrate (10) according to claim 1, **characterized in that**, at the level of said at least one second portion (22) of the buffer structure (2), the stack (221) alternating layers of InGaN and intermediate layers of GaN is at least partially formed on the upper face (1a) of the substrate (1), **in that** it comprises a nucleation layer formed on the upper face (1a) of the substrate (1) and **in that**, at the level of said at least one second portion (22) of the buffer structure (2), the stack (221) alternating layers of InGaN and intermediate layers of GaN is at least partially formed on the nucleation layer.

3. The pseudo-substrate (10) according to claim 2, **characterized in that** the stack (221) alternating layers of InGaN and intermediate layers of GaN of said at least one second portion (22) is in the form of at least one wire-shaped or pyramid-shaped nano-element.

4. The pseudo-substrate (10) according to any one of claims 1 to 3, **characterized in that** the buffer structure (2) comprises at least one third portion (23) where a stack (231) alternating layers of InGaN and intermediate layers of GaN and wherein the indium is present in a second mass proportion strictly different from the first mass proportion, delimits at least one free surface of a third type (230) turned on the side opposite to the upper face (1a) of the substrate (1), each free surface of the third type (230) being suitable for the growth thereon of at least one light-emitting diode (13) mainly based on a III-V compound capable of emitting light (L3) at a third wavelength different from the first wavelength and from the second wavelength, and **in that** said at least one third portion (23) of the buffer structure (2) is offset with respect to said at least one first portion (21) of the buffer structure (2) and with respect to said at least one second portion (22) of the buffer structure (2) in the general plane (P) oriented parallel to the plane of the upper face (1a) of the substrate (1).

5. The pseudo-substrate (10) according to claim 4, **characterized in that**, at the level of said at least one third portion (23) of the buffer structure (2), the stack (231) alternating layers of InGaN and intermediate layers of GaN is at least partially formed on the upper face (1a) of the substrate (1), **in that** it comprises a nucleation layer formed on the upper face (1a) of the substrate (1) and **in that**, at the level of said at least one third portion (23) of the buffer structure (2), the stack (231) alternating layers of InGaN and intermediate layers of GaN is at least partially formed on the nucleation layer.

6. The pseudo-substrate (10) according to any one of claims 4 or 5, **characterized in that** the stack (231) alternating layers of InGaN and intermediate layers of GaN of said at least one third portion (23) is in the form of at least one wire-shaped or pyramid-shaped nano-element.

7. The pseudo-substrate (10) according to any one of claims 4 to 6, **characterized in that** the second mass proportion of the indium at the level of said at least one third portion (23) is included in a range between 5 and 25%, preferably between 10 and 20%.

8. The pseudo-substrate (10) according to any one of claims 1 to 7, **characterized in that** the first mass proportion of the indium at the level of said at least one second portion (22) is included in a range between 5 and 25%, preferably between 10 and 20%.

9. An optoelectronic device (100) comprising a pseudo-substrate (10) according to any one of claims 1 to 8 and:
- at least one light-emitting diode (11) mainly based on a III-V compound formed by growth on the free surface of the first type (210) of said at least one first portion (21) of the buffer structure (2) of the pseudo-substrate (10) and capable of emitting light (L1) at the first wavelength,
- at least one light-emitting diode (12) mainly based on a III-V compound formed by growth on the free surface of the second type (220) of said at least one second portion (22) of the buffer structure (2) of the pseudo-substrate (10) and capable of emitting light (L2) at the second wavelength different from the first wavelength.

10. The optoelectronic device (100) according to claim 9, **characterized in that** the pseudo-substrate (10) being according to any one of claims 4 to 7, or according to claim 8 and any one of claims 4 to 7, the optoelectronic device (100) comprises at least one light-emitting diode (13) mainly based on a III-V compound formed by growth on the free surface of the third type (230) of said at least one third portion (23) of the buffer structure (2) of the pseudo-substrate (10) and capable of emitting light (L3) at the third wavelength different from the first wavelength and from the second wavelength.

11. A method for manufacturing a pseudo-substrate (10) according to any one of claims 1 to 8, **characterized in that** it comprises a first step of providing the substrate (1), a second step of forming the layer (211) formed in bulk GaN on the upper face (1a) of the substrate (1), a third step of forming the stack (221) alternating layers of InGaN and intermediate layers of GaN and wherein the indium is present in the first mass proportion, on the layer (211) resulting from the second step and/or on the upper face (1a) of the substrate (1).

12. The method for manufacturing a pseudo-substrate (10) according to claim 11, **characterized in that** the third step comprises successive steps of depositing layers of InGaN and intermediate layers of GaN in openings (31) delimited by a first mask (30) covering the layer (211) of bulk GaN resulting from the second step.

13. The method for manufacturing a pseudo-substrate (10) according to claim 11, **characterized in that** the third step comprises a first set of successive steps of depositing layers of InGaN and intermediate layers of GaN on the entire surface of the layer (211) resulting from the second step, then a first etching step (G1) through a stack (50) which results from said first set of successive deposition steps, said first etching step (G1) being carried so as to make determined surfaces of the layer (211) which results from the second step free, said surfaces made free corresponding to the free surfaces of the first type (210) of said at least one first portion (21) of the buffer structure (2).

14. The method for manufacturing a pseudo-substrate (10) according to any one of claims 11 to 13, **characterized in that** the pseudo-substrate (10) being according to any one of claims 4 to 7, or according to claim 8 and any one of claims 4 to 7, the method comprises a fourth step of forming the stack (231) alternating layers of InGaN and intermediate layers of GaN and wherein the indium is present in the second mass proportion, on the layer (211) resulting from the second step and/or on the stack (221) resulting from the third step.

15. The method for manufacturing a pseudo-substrate (10) according to claim 14, **characterized in that** the fourth step comprises successive steps of depositing layers of InGaN and intermediate layers of GaN in all or part of the surface of openings (41) of a second mask (40) covering at least the layer (211) of bulk GaN which results from the second step.

16. The method for manufacturing a pseudo-substrate (10) according to claims 13 and 14, **characterized in that** the fourth step comprises a second set of successive steps of depositing layers of InGaN and intermediate layers of GaN on the entire surface of the stack (50) resulting from the first set of successive deposition steps, then a second etching step (G2) through a stack (60) which results from said second set of successive deposition steps, said second etching step being carried out so as to make determined surfaces of the stack (50) which results from the first set of successive deposition steps free, said surfaces made free corresponding to the free surfaces of the second type (220) of said at least one second portion (22) of the buffer structure (2).
